Europäisches Patentamt

European Patent Office

Office européen des brevets

(11) Publication number: **0 456 921 A1**

## EUROPEAN PATENT APPLICATION

(21) Application number: 90305146.4

(51) Int. Cl.⁵: **H01P 1/22**, H03H 7/25

(22) Date of filing: **14.05.90**

(43) Date of publication of application:
**21.11.91 Bulletin 91/47**

(84) Designated Contracting States:
**AT BE CH DE DK ES FR GB GR IT LI LU NL SE**

(71) Applicant: **Hewlett-Packard Company**
**Mail Stop 20 B-O, 3000 Hanover Street**
**Palo Alto, California 94304(US)**

(72) Inventor: **Reading, Ian**
**3 Stoneyflatts Crescent, South Queensferry**
**West Lothian, Scotland(GB)**

(74) Representative: **Smith, Norman Ian et al**
**F.J. CLEVELAND & COMPANY 40-43**
**Chancery Lane**
**London WC2A 1JQ(GB)**

(54) **Attenuator.**

(57) An attenuator comprises a plurality of attenuation stages (10, 11, 12, 14) which are selectively switchable into or out of a signal path by switches (18 to 25) to provide a desired attenuation level. The switches may be RF switches such as PIN diodes or GaAs FET switches. The attenuator includes a switchable gain stage 16 which can be switched into the signal path to compensate for loss resulting from the switches.

FIG.1.

GAIN PAD

EP 0 456 921 A1

This invention relates to attenuators. The invention has particular application to stepped attenuators.

Stepped attenuators are used in signal generators to provide the generator with a range of output powers. A stepped attenuator comprises a series of attenuator stages which can be switched into or out of a signal path to provide a desired attenuation factor and hence signal level. The stepped attenuator is usually used to provide a coarse adjustment over the output range of the instrument and other circuitry provides fine adjustment within the coarse steps of the attenuator.

It has been the practice to use solenoid actuated RF relay switches to switch the attenuator stages. The operation of the switches is usually carried out under microprocessor control. Attenuators using this type of switch have proved to be unreliable. The switches have movable contacts and are not capable of functioning reliably in applications where they may have to switch several times during a relatively short time.

For this reason attenuators have been developed which use RF switches with no moving parts. Examples of such switches are PIN diodes and GaAs FET switches. A problem with this type of switch is that they have a finite resistance when in an "on" state and a finite capacitance when in an "off" state. As a consequence they can introduce significant loss into the signal path of the attenuator particularly at higher frequencies (in the GHZ range).

Attempts have been made to find attenuator structures which minimise this problem. One such structure is the step ladder attenuator. This uses a network of resistors which are connected so that they resemble a step ladder. The resistors can be switched into or out of the signal path by RF switches which are single pole, single throw (SPST) switches. This type of attenuator has been found to reduce the problem of loss, but it is relatively complex and expensive to assemble and its loss is still significant at higher frequencies (> 1 GHZ).

According to the present invention there is provided a stepped attenuator having one or more attenuation stages which can be switched into or out of a signal path, said attenuator also including a gain stage which can be selectively switched into the signal path.

The gain stage can used to compensate for any loss introduced by the siwtches which are used to switched the various stages. In a signal generator the gain stage will typically be the final stage. Another application of the present attenuator is in a receiver where the gain stage will typically be the first stage.

The switches may be RF switches such as PIN diodes or GaAs FET switches.

The use of the gain stage has two significant advantages. For lower frequency applications (< 2 GHZ) it permits the attenuator to be constructed using less expensive and complex assembly techniques than for example are required in the step ladder design. Additionally it enables attenuators using RF switches to be used over much wider bandwidths than has been possible with known attenuator structures.

The attenuator may include temperature compensation means for compensating for variations due to temperature changes.

The invention will be described now by way of example only, with particular reference to the accompanying drawings. In the drawings:

Figure 1 is a schematic view of an attenuator in accordance with the present invention;

Figure 2 is a block schematic diagram of a signal generator employing the present attenuator;

Figure 3 is a more detailed circuit diagram of an attenuator in accordance with the present invention, and Figure 4 shows a gain stage which includes a compensation circuit.

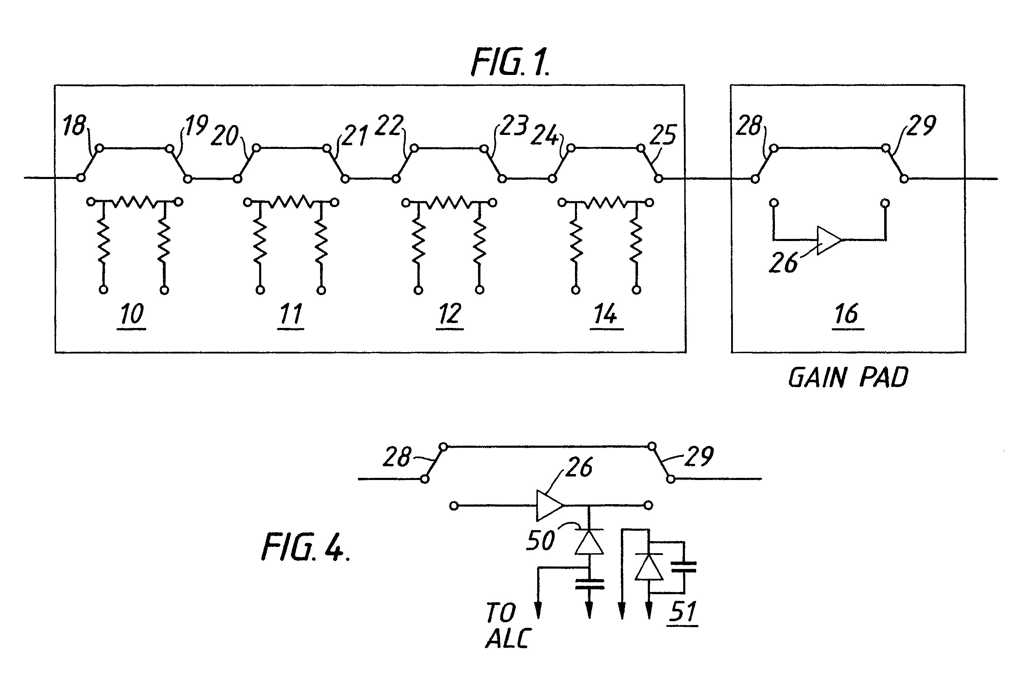

Referring to Figure 1 an attenuator comprises a series of attenuation stages 10, 11, 12, 14 and a gain stage 16. Each attenuation stage comprises a resistive attenuator which can be switched into or out of the signal path by double pole, double throw switches 18 to 25. These switches can be PIN diodes or GaAs FET switches. The gain stage 18 includes an amplifier 26 which can also be switched into or out of the signal path by switches 28, 29 which are similar to the switches 18 to 25.

It will be appreciated that an appropriate attenuation of an input signal can be obtained by switching selected ones of the attenuation stages 10 to 14 into the signal path by operation of the switches 18 to 25. If compensation for signal loss is required the amplifier 26 is switched into the signal path to provide the necessary gain factor. The gain provided by the amplifier is intended to match the loss resulting from the switches used in the attenuation stages. The use of the gain stage in addition to compensating for loss through the attenuation stages enables high output power levels to be achieved with the moderate amplifier power.

As shown in Figure 1 the attenuation stages uses a double pole, double throw structure. It will be apparent to those skilled in the art that the gain stage can be used with other types of attenuator structure such as the step ladder structure.

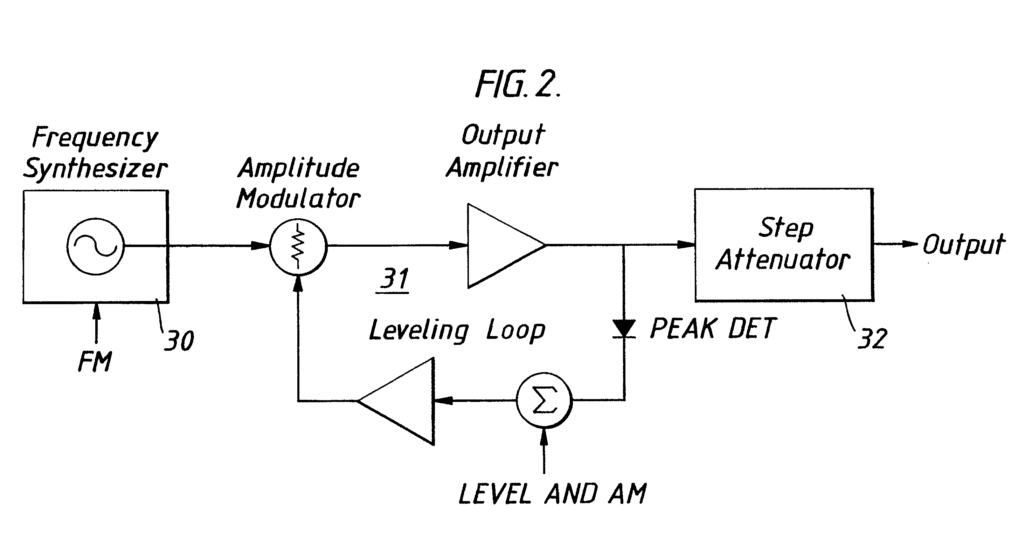

Figure 2 shows how the attenuator would be used in a signal generator. The generator includes a frequency synthesiser 30 which provides an output to a levelling loop 31 which then feeds the stepped attenuator 32. It will be appreciated by those skilled in the art that the attenuator 32 can be ajdusted under micorprocessor control to provide the required output level.

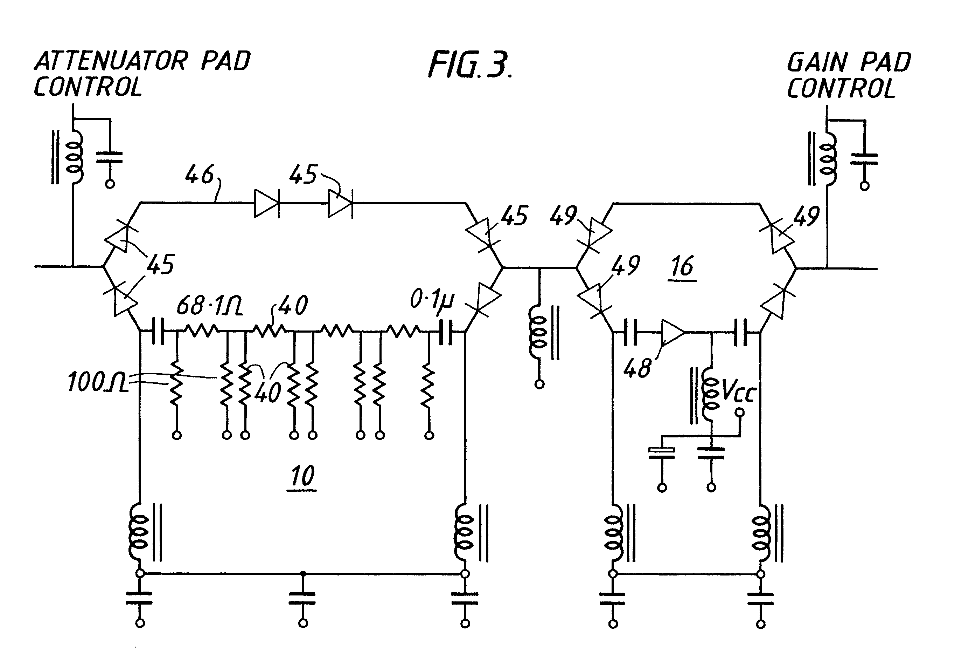

Figure 3 shows in more detail an example of the present attenuator. This attenuator has a single attenuation stage 10 and a gain stage 16. The resistors 40 which make up the attenuation stage can provide 40dB of attenuation. The switches 45 are PIN diodes. Four such diodes are provided in the through path 46 (no attenuation). Four such switches are required to provide the necessary isolation. The gain stage 16 uses an Avantek MSA0520 RF amplifier 48. The gain stage also uses PIN diode switches 49 which are used to switch the amplifier into the signal path when required. The amplifier 48 is designed to provide 7dB of gain.

It will be appreciated that an instrument incorporating the present attenuator, such as that shown in Figure 2, can be calibrated to provide compensation for device to device variation. This can be achieved by measuring the output power of the instrument for each attenuator setting over a range of frequencies. The measured levels are used to compute a table of correction factors which are stored in ROM within the instrument. This data is used by the control microprocessor to control the circuitry which makes the fine adjustment of the attenuation values to compensate for device variations.

Temperature changes can also affect attenuator operation since they will change the gain of the gain stage and the loss through the switches controlling the attenuation stages. To compensate for temperature changes a temperature sensor can be mounted in the attenuator housing. The sensor is connected to the control microprocessor. A table of loss and gain correction factors can be stored in ROM and used by the microprocessor to provide the appropriate correction factor in accordance with the sensed temperature.

The gain of the amplifier in the gain stage can be stabilised using a detector as shown in Figure 4. This shows the gain stage which includes a detector diode 50 which can be a Schotky diode. The Schotky diode 50 senses RF power and provides an input to the automatic level control circuits of the instrument to provide a correction factor for temperature dependent gain variation. The circuit elements 51 provide temperature compensation for the detector diode 50.

The above description relates to the use of the present attenuator in a signal generator. The attenuator has other applications and can be used in a receiver of, for example, a spectrum analyser. Such receivers often use stepped attenuators to improve dynamic range. Loss in the attenuators of such devices raises the noise level of the measurement process and can therefore be important. The present attenuator would alleviate the problem of such loss. When the attenuator is used in such an application the gain stage would be provided at the input to the attenuator stages.

**Claims**

1.  An attenuator comprising one or more attenuation stages (10, 11, 12, 14) which can be switched into or out of a signal path, characterised in that said attenuator also including a gain stage (16) which can be selectively switched into the signal path.

2.  An attenuator according to claim 1, wherein the stages (10, 11, 12, 14, 16) can be switched by RF switches (18 to 25, 28, 29).

3.  An attenuator according to claim 2, wherein the switches (18 to 25, 28, 29) are PIN diodes or GaAs FET switches.

4.  An attenuator according to any preceding claim, wherein the gain stage (16) follows the attenuation stages (10, 11, 12, 14).

5.  An attenuator according to any one of claims 1 to 3, wherein the attenuation stages (10, 11, 12, 14) follow the gain stage (16).

6.  An attenuator according to any preceding claim including temperature compensation means for compensating for variations due to temperature changes.

7.  An attenuator according to any one of claims 1 to 5, wherein the gain stage includes RF detection means (50) for providing gain compensation signals to enable stabilisation of the gain of the gain stage.

FIG.1.

GAIN PAD

FIG.4.

TO ALC

# FIG.2.

Frequency Synthesizer 30 — FM — Amplitude Modulator — 31 — Output Amplifier — PEAK DET — Step Attenuator 32 — Output

Leveling Loop — Σ — LEVEL AND AM

EP 0 456 921 A1

ATTENUATOR PAD
CONTROL

FIG.3.

GAIN PAD
CONTROL

EP 0 456 921 A1

# EUROPEAN SEARCH REPORT

Application Number

**EP 90 30 5146**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | WIRELESS WORLD. vol. 81, no. 1473, May 1975, HAYWARDS HEATH GB pages 211 - 215; C. Little: "a 50 MHz Oscilloscope" <br> * page 212, right-hand column, paragraphs 4 - 5; figures 3, 4 * | 1,5 | H 01 P 1/22 <br> H 03 H 7/25 |
| A | EP-A-0 210 783 (HEWLETT-PACKARD) <br> * page 3, paragraph 2 - page 4, paragraph 1; figures * | 1-3 | |
| A | ELECTRONIC DESIGN. vol. 25, no. 7, 29 March 1977, HASBROUCK HEIGHTS, N pages 100 - 102; R. S. Viles: "Need a PIN-Diode Attenuator?" <br> * figures 3, 4 * | 6 | |
| A | IEEE TRANSACTIONS ON MICROWAVE THEORY AND TECHNIQUES. vol. 28, no. 7, July 1980, NEW YORK US pages 774 - 776; F. Ananasso: "A Low Phase Shift Step Attenuator Using p-i-n Diodes Switches" <br> * figure 1 * | 1 | |
| A | PATENT ABSTRACTS OF JAPAN vol. 11, no. 254 (E-533)(2701) 18 August 1987, <br> & JP-A-62 064111 (TAMAGAWA DENSHI K. K.) 23 March 1987, <br> * the whole document * | 1-3 | TECHNICAL FIELDS SEARCHED (Int. Cl.5) <br> <br> H 03 H <br> H 03 G <br> H 01 P <br> G 01 R |
| A | MICROWAVE JOURNAL. Suppl., no. 9, September 1989, DEDHAM US pages 95 - 112; A. Sharma: "Solid-State Control Devices: State of the Art" | | |

The present search report has been drawn up for all claims

| Place of search | Date of completion of search | Examiner |
|---|---|---|
| The Hague | 15 January 91 | BLAAS D.-L.A.J. |